# EUROPEAN PATENT APPLICATION

(11) **EP 4 227 692 A1**
(43) Date of publication of application: **16.08.2023**
(21) Application number: 22739003.6
(22) Date of filing: 11.01.2022
(51) Int. Cl.: G01R 31/14, G01R 31/52

(54) **MODULAR BATCH ENERGY ACQUISITION AND COMMUTATION CIRCUIT AND CONTROL METHOD**

(30) Priority: 13.01.2021 CN 202110042119; 20.04.2021 CN 202110425656; 09.09.2021 CN 202111056378; 09.09.2021 CN 202111056427
(71) Applicant: NR ELECTRIC CO., LTD., Jiangning Nanjing, Jiangsu 211102 (CN); NR Engineering Co., Ltd., Nanjing, Jiangsu 211102 (CN)
(72) Inventor: XIE, Yeyuan, Nanjing, Jiangsu 211102 (CN); WANG, Yu, Nanjing, Jiangsu 211102 (CN); YAO, Hongyang, Nanjing, Jiangsu 211102 (CN); JIANG, Tiangui, Nanjing, Jiangsu 211102 (CN); ZHU, Minglian, Nanjing, Jiangsu 211102 (CN); OUYANG, Youpeng, Nanjing, Jiangsu 211102 (CN); HU, Zhaoqing, Nanjing, Jiangsu 211102 (CN); LI, Haiying, Nanjing, Jiangsu 211102 (CN); YIN, Guanxian, Nanjing, Jiangsu 211102 (CN); DUAN, Jun, Nanjing, Jiangsu 211102 (CN); REN, Tieqiang, Nanjing, Jiangsu 211102 (CN)
(74) Representative: Kurig, Thomas
(86) International application number: PCT/CN2022/071342
(87) International publication number: WO 2022/152124

(57) **Abstract**

Disclosed are a modular converter circuit featuring batch energy harvesting, and a control method. The modular converter circuit featuring batch energy harvesting comprises a batch energy harvesting unit and N sub-modules, wherein AC terminals of the N sub-modules are connected in series, and N is an integer greater than or equal to 2. The sub-module comprises: a power unit (1) comprising a power semiconductor device, an AC terminal of the power unit (1) being led out as the AC terminal of the sub-module; and a capacitor unit (2) connected in parallel with the power unit (1). The batch energy harvesting unit comprises: a first energy harvesting power supply (6), a negative electrode of the first energy harvesting power supply (6) being connected with a negative electrode of the capacitor unit (2) of a head-end sub-module among the N sub-modules or connected therewith through a current limiting unit; and a connection network (30), an input terminal of the connection network (30) being directly connected with a positive electrode of the first energy harvesting power supply (6) or connected therewith through a current limiting unit, and N output terminals of the connection network (30) being respectively connected with positive electrodes of the capacitor units (2) or connected therewith through current limiting units.

## Description

### Technical Field

The application relates to the technical field of high-power power electronic converters, in particular to a modular converter circuit featuring batch energy harvesting and a control method.

### Background

With the application and development of power electronics technology in power systems, power electronic equipment is developing towards high voltage, large capacity and modularization, especially in HVDC flexible systems and chain static var generators. The HVDC flexible system is generally composed of several sub-modules connected in series or parallel.

After the sub-modules are transported to the site and assembled into a valve tower, due to possible accidents during transportation and installation, it is necessary to test the functions of the sub-modules and the whole converter circuit again to ensure the smooth operation of the equipment.

Take a high-voltage and large-capacity HVDC flexible system as an example. A bridge arm contains hundreds of sub-modules. The test scheme in the prior art requires a test power supply to be applied to each sub-module separately for function testing, which has the following problems:

(1) The number of sub-modules is large, the test workload is heavy, the test time is long, the test difficulty is high, and operation is hard after the sub-modules form the valve tower; (2) optical fibers need to be plugged and unplugged in the testing process, which may cause damage to optical fiber interfaces and the optical fibers themselves, and frequent plugging and unplugging will also affect the service life, thus adversely affecting the reliability of the equipment; and (3) in the process of testing or maintenance, if a control unit program of the sub-module needs to be changed, the workload will be heavy because a power supply needs to be applied separately, and moreover, manual operation is not reliable.

In one aspect, the existing test scheme can only perform partial system testing such as sub-module function testing and insulation testing, and a high-voltage and high-power operation test scheme for the whole converter circuit is not available now, resulting in incompleteness of test items and low test efficiency.

In another aspect, at the initial stage of installation and debugging, there may be many faulty sub-modules in the batch of sub-modules. If automatic testing is adopted, each of the sub-modules connected in series is required to be able to establish communication with a valve control device, the sub-module control unit and drive and power devices are all normal, and a zero-level state is output. Once a sub-module fails, the test will be interrupted, and it will take a long time to discharge and repair, which will affect the test efficiency. After the test, a bypass switch of the sub-module needs to be manually opened, which may not be properly done.

Take an offshore wind power HVDC flexible system as an example. Offshore wind power grid connection is an important application of HVDC flexible, and an HVDC flexible offshore converter station needs to be built on an offshore platform. Considering the limitation of offshore construction conditions, it is impossible to install and test large-scale equipment at sea, and it is necessary to install and debug the equipment on the dock and then send the whole offshore platform to a designated sea area. If large-scale equipment is found to have quality defects after the offshore HVDC flexible converter station arrives at the designated sea area, the whole platform needs to be transported to a test dock for treatment, which requires a lot of expenses and very long time.

Therefore, for the above application conditions, it is very important to test the equipment on the dock, but generally, the dock can only provide a low-voltage power supply with small capacity, while the converter circuit needs to be tested with high voltage according to the existing test technology.

In order to solve the above problems, the application provides a modular converter circuit featuring batch energy harvesting and a control method.

The above information disclosed in the background art is only used to enhance the understanding of the background of the invention, so it may contain information that does not constitute the prior art known to those of ordinary skill in the art.

### Summary

According to one aspect of the application, a modular converter circuit featuring batch energy harvesting is proposed. The modular converter circuit featuring batch energy harvesting comprises a batch energy harvesting unit and N sub-modules, wherein AC terminals of the N sub-modules are connected in series, and N is an integer greater than or equal to 2. The sub-module comprises: a power unit comprising a power semiconductor device, an AC terminal of the power unit being led out as the AC terminal of the sub-module; and a capacitor unit connected in parallel with the power unit. The batch energy harvesting unit comprises: a first energy harvesting power supply, a negative electrode of the first energy harvesting power supply being connected with a negative electrode of a capacitor unit of a head-end sub-module among the N sub-modules or connected therewith through a current limiting unit; and a connection network, an input terminal of the connection network being directly connected with a positive electrode of the first energy harvesting power supply or connected therewith through a current limiting unit, and N output terminals of the connection network being respectively connected with positive electrodes of the capacitor units or connected therewith through current limiting units.

According to some embodiments, the power units of the sub-modules in the converter circuit are all half-bridge circuits, all full-bridge circuits, or a mixed configuration of full-bridge circuits and half-bridge circuits; the half-bridge circuit comprises an upper tube and a lower tube, the upper tube and the lower tube are connected in series and then connected in parallel with the capacitor unit, and a collector and an emitter of the upper tube or the lower tube are led out as the AC terminal of the sub-module; the full-bridge circuit comprises two upper tubes and two low tubes, the two upper tubes and the two lower tubes are connected in series to form a bridge arm and the bridge arm is connected in parallel with the capacitor unit, and a midpoint of the bridge arm is led out as the AC output terminal of the sub-module; and the upper tubes and the lower tubes are fully controlled power semiconductor devices or formed by parallel connection of the devices.

According to some embodiments, the connection network comprises: a parallel connection network comprising N diode units, positive electrodes of the N diode units being connected together as the input terminal of the connection network, and negative electrodes of the N diode units being sequentially led out as N output terminals of the connection network; or a series connection network comprising any of the following two Types:
Type 1: comprising N diode units connected in series in a same direction, a positive electrode of the first diode unit being used as the input terminal of the connection network, and negative electrodes of N^{th} diode units being led out in turn as the output terminals of the connection network; and
Type 2: comprising N-1 diode units connected in series in a same direction, a positive electrode of a first diode unit being used as the input terminal of the connection network, and a positive electrode of the first diode and a negative electrode of an (N-1)^{th} diode unit being sequentially led out as the output terminals of the connection network;
   wherein the diode unit comprises a diode, or a diode and a resistor and/or an inductor connected in series.

According to some embodiments, the converter circuit further comprises: bypass switches connected in parallel with the AC terminals of the sub-modules; and a discharge branch being connected in parallel with the converter circuit, and comprising a discharge switch and a discharge resistor connected in series and/or a resonant circuit formed by an inductor and/or an inductor capacitor.

According to some embodiments, the head-end sub-module is a sub-module with a lowest potential in the converter circuit. According to another aspect of the application, a method for controlling the converter circuit according to any one of the preceding paragraphs is proposed, which comprises one or a combination of the following steps: batch trial pre-testing of sub-module functions: starting the first energy harvesting power supply, closing the discharge switch, and charging the capacitor unit of the sub-module through the connection network and the discharge resistor; batch progressive boosting testing of sub-modules: starting the first energy harvesting power supply, progressively controlling, by a sub-module control unit, the sub-module to output a zero-level state, and charging the capacitor units of the sub-modules one by one, and performing sub-module function testing; batch rapid discharge testing of sub-modules: after the batch trial pre-testing of sub-module functions or the batch progressive boosting testing of sub-modules is completed, disconnecting the first energy harvesting power supply, closing the discharge switch, progressively turning on power semiconductor devices at corresponding positions in the power units through the sub-module control unit, and discharging the capacitor units of the sub-modules one by one; and batch discharge bypass testing of sub-modules: after the batch rapid discharge testing of sub-modules is completed, discharging the capacitor unit of the sub-module to a constant value, and closing the bypass switch of the sub-module automatically.

According to some embodiments, the batch progressive boosting testing of sub-modules comprises: starting the first energy harvesting power supply to charge the capacitor unit of the sub-module connected therewith; supplying power to the sub-module control unit after the capacitor unit is charged to a threshold value; controlling, by the sub-module control unit, the power semiconductor device at the corresponding position in the power unit to be turned on to realize a zero-level state of the power unit, so as to establish a turn-on loop for the capacitor unit of an adjacent sub-module; charging, by the first energy harvesting power supply or the capacitor unit of a preceding sub-module, the capacitor unit of the adjacent sub-module so that the sub-module control unit of the adjacent sub-module is charged; and charging the capacitor units of all the sub-modules in turn so that the N sub-module control units are charged.

According to some embodiments, for a half-bridge circuit, a state that the low tube of the power semiconductor device is turned on is defined as the zero-level state; and for a full-bridge circuit, a state that the two upper tubes of the power semiconductor device are turned on simultaneously or the two lower tubes of the power semiconductor device are turned on simultaneously is defined as the zero-level state.

According to another aspect of the application, a high voltage operation circuit is proposed, which comprises the modular converter circuit featuring batch energy harvesting according to any one of the preceding paragraphs and a second converter circuit, wherein the second converter circuit comprises M sub-modules, AC terminals of the M sub-modules are connected in series, and M is an integer greater than or equal to 2; or the second converter circuit comprises the converter circuit featuring batch energy harvesting according to any one of the preceding paragraphs; AC terminals of a head-end sub-module and a tail-end sub-module of the second converter circuit are led out as AC terminals of the second converter circuit; and the converter circuit featuring batch energy harvesting is connected with an AC terminal of the second converter circuit through a connection reactor, and another AC terminal thereof is short-circuited.

According to another aspect of the application, a method for controlling the high voltage operation circuit comprising the converter circuit as mentioned above is proposed, which comprises: cascade charging control: using the first energy harvesting power supply and the connection network to charge the capacitor units of all the sub-modules, and after the sub-module control unit takes power from the capacitor units, enabling the sub-module control unit to operate; and cascade operation control: after the cascade charging control is completed, controlling voltage and current by the converter circuit featuring batch energy harvesting and the second converter circuit, and supplementing lost energy for the converter circuit featuring batch energy harvesting and the second converter circuit by the first energy harvesting power supply.

According to another aspect of the application, a low-voltage boosting system of an HVDC flexible converter station is proposed. The HVDC flexible converter station comprises an HVDC flexible converter valve and a valve controller; the HVDC flexible converter valve comprises three phase bridge arms connected in parallel, the phase bridge arm is formed by series connection of an upper bridge arm and a lower bridge arm, a positive terminal of the upper bridge arm is connected with a DC positive electrode, a negative terminal of the upper bridge arm is connected with a positive terminal of the lower bridge arm, and a negative terminal of the lower bridge arm is connected with a DC negative electrode; according to a grounding mode of the HVDC flexible converter valve, the corresponding upper bridge arm or lower bridge arm or phase bridge arm is configured as the converter circuit featuring batch energy harvesting according to any one of the preceding paragraphs, and other bridge arms are configured as converter circuits where sub-modules are connected in series; and the valve controller communicates with a sub-module control unit controlling the operation of the sub-modules.

According to some embodiments, a configuration mode has one of the following corresponding relationship with the grounding mode: the DC negative electrode of the HVDC flexible converter valve is grounded, and at least one lower bridge arm or phase bridge arm is configured as the converter circuit featuring batch energy harvesting; the DC positive electrode of the HVDC flexible converter valve is grounded, the first energy harvesting power supply is isolated from the capacitor unit by an isolation module, and the upper bridge arm, the lower bridge arm or the phase bridge arm is configured as the converter circuit featuring batch energy harvesting; when absolute values of the voltage to ground of the DC positive electrode and the DC negative electrode of the HVDC flexible converter valve are equal to or close to each other, the upper bridge arm or the phase bridge arm is configured as the converter circuit featuring batch energy harvesting; and the HVDC flexible converter valve is not grounded or grounded through a grounding switch turned off, and the upper bridge arm or the lower bridge arm or the phase bridge arm is configured as the converter circuit featuring batch energy harvesting.

According to another aspect of the application, a method for controlling the low-voltage boosting system of the HVDC flexible converter station according to any one of the preceding paragraphs is proposed, comprising: charging, by the first energy harvesting power supply, the DC capacitor of the sub-module configured as the converter circuit featuring batch energy harvesting, the converter circuit featuring batch energy harvesting being defined as a charging bridge arm; starting the charging bridge arm after charging of the charging bridge arm is completed, to output controllable voltage to charge other bridge arms of the HVDC flexible converter valve; and controlling the upper bridge arm and the lower bridge arm of any phase to be voltage sources after charging of the other bridge arms are completed, and equivalently applying DC voltage to the DC positive electrode and the DC negative electrode, the process being defined as a boosting process.

According to some embodiments, a first high-voltage switch connected in series with the first energy harvesting power supply is further provided, after charging of the three-phase bridge arm is completed, the first high-voltage switch is turned off, the three-phase bridge arm is unlocked, the DC positive electrode and the DC negative electrode feature a DC voltage, and a midpoint of the three-phase bridge arm features a three-phase AC voltage.

According to some embodiments, the method also comprises: performing voltage withstand testing and/or sampling calibration on DC, AC equipment or AC/DC lines during boosting; and ensuring safety of equipment by means of rapid overcurrent protection of the bridge arm and/or short-circuit protection of the power semiconductor device when insulation breakdown occurs in the process of boosting.

According to another aspect of the application, a field test method for a converter valve is provided. The converter valve comprises six bridge arms and a valve control unit, the bridge arm comprises the converter circuit according to any one of the preceding paragraphs is proposed, the converter circuit comprises N sub-modules, and the sub-modules are connected with a valve control unit by optical fibers; and the field test method comprises: connecting N output terminals of the connection network to positive electrodes of the capacitor units of the N sub-modules; starting the first energy harvesting power supply; identifying, by the valve control unit, whether the sub-module established by communication is consistent with a physical position; and performing batch energy harvesting, and performing function testing on the sub-modules or updating a program of the valve control unit.

According to exemplary embodiments, the application has one or more of the following beneficial effects:
(1) according to the modular converter circuit featuring batch energy harvesting provided by this application, a sub-module capacitor is divided into two capacitors, which realizes flexible adaptation according to different designs of internal power supply units; the capacitors can realize quick charging to supply power to the sub-module control unit, or a charging method equivalent to the real working condition can be adopted, but fewer external power supplies and lower voltage are used to ensure the safety of equipment and people; after the sub-module control unit is powered on, a communication point-to-point test can be carried out, and the step-by-step testing method can reduce test risks and improve test reliability;
(2) this application proposes a scheme featuring power complementation of two converter chains; one converter chain is charged by a low-voltage power supply, and the other converter chain can be charged by the output voltage of one converter chain; power complementation of two converter chains is realized simply by adding a connection reactor, and a bridge arm reactor in a project may serve as the connection reactor; this scheme is low in cost and high in reliability, which solves the problem that it is difficult for an existing converter chain to perform high-voltage and high-power operation tests; and
(3) the low-pressure boosting test system and the control method provided by the invention can perform batch detection on the sub-modules, thus improving test efficiency; moreover, the system automatically opens the bypass switch of the sub-module, which solves the problem that manual opening may be improper.

It should be understood that the above general description and the following detailed description are only exemplary, and do not limit the application.

### Brief Description of the Drawings

The above and other objects, features and advantages of the application will become more apparent by describing in detail exemplary embodiments with reference to the accompanying drawings. The drawings described below only illustrate some embodiments of the application, and do not limit the application.
Fig. 1 is a composition diagram of a modular converter circuit featuring batch energy harvesting according to an embodiment of the application;
Fig. 2 is a composition diagram of a capacitor unit according to an embodiment of the application;
Fig. 3a is a composition diagram of a power unit composed of a half-bridge circuit according to an embodiment of the application;
Fig. 3b is a composition diagram of a power unit composed of a full-bridge circuit according to an embodiment of the application;
Fig. 3c is a composition diagram of a power unit according to an embodiment of the application;
Fig. 4 is a composition diagram of an interface unit in a high impedance mode according to an embodiment of the application;
Fig. 5 is a composition diagram of an interface unit in a blocking mode according to an embodiment of the application;
Fig. 6 is a composition diagram of a transformer unit according to an embodiment of the application;
Fig. 7 is a composition diagram of another transformer unit according to an embodiment of the application;
Fig. 8 is a composition diagram of a parallel connection network according to an embodiment of the application;
Fig. 9a is a composition diagram of a series connection network according to an embodiment of the application;
Fig. 9b is another embodiment of the composition diagram of a series connection network according to the application;
Fig. 10 is a composition diagram of a connection network in which a plurality of first energy harvesting power supplies are connected in series according to an embodiment of the application;
Fig. 11 is a composition diagram of a synthetic loop system of a modular converter circuit featuring batch energy harvesting according to an embodiment of the application;
Fig. 12 is a flowchart of a charging control method of a modular converter circuit featuring batch energy harvesting according to an embodiment of the application;
Fig. 13 is a circuit structure diagram of a converter valve low-voltage boosting test system according to an embodiment of the application;
Fig. 14 is a circuit structure diagram of another converter valve low-voltage boosting test system according to an embodiment of the application;
Fig. 15 shows a flowchart of a control method of batch trial pre-testing of sub-module functions according to an exemplary embodiment;
Fig. 16 shows a diagram of a sub-module charging circuit according to an exemplary embodiment;
Fig. 17 shows a flowchart of a control method of batch progressive boosting testing of sub-modules according to an exemplary embodiment;
Fig. 18 shows a flowchart of a control method of batch rapid discharge testing of sub-modules according to an exemplary embodiment;
Fig. 19 shows a flowchart of a control method of batch discharge bypass testing of sub-modules according to an exemplary embodiment.
Fig. 20 is a diagram of a high voltage operation circuit of a converter valve provided by an embodiment of the application;
Fig. 21 is a diagram of another high voltage operation circuit of a converter valve provided by an embodiment of the application;
Fig. 22a is a diagram of a diode unit provided by an embodiment of the application;
Fig. 22b is a diagram of another diode unit provided by an embodiment of the application;
Fig. 23 is a diagram of a field test system for a high voltage operation circuit of a converter valve provided by an embodiment of the application;
Fig. 24 is a diagram of a field test system for another high voltage operation circuit of a converter valve provided by an embodiment of the application;
Fig. 25 is a diagram of wiring of a field test system for a high voltage operation circuit of a converter valve provided by an embodiment of the application;
Fig. 26 is a diagram of single-bridge arm wiring of a field test system for a high voltage operation circuit of a converter valve provided by an embodiment of the application;
Fig. 27 is a flowchart of a control method for a high voltage operation circuit of a converter valve provided by an embodiment of the application;
Fig. 28 is a flowchart of sequential control startup logic provided by an embodiment of the application;
Fig. 29 is a flowchart of DC charging logic provided by an embodiment of the application;
Fig. 30 is a flowchart of cascade operation control provided by an embodiment of the application;
Fig. 31 is a flowchart of bypass detection after operation provided by an embodiment of the application;
Fig. 32 is a flowchart of cascade operation control bypass detection provided by an embodiment of the application;
Fig. 33 is a diagram of a low-voltage boosting system of an HVDC flexible converter station according to an embodiment of the application;
Fig. 34 is a diagram of another low-voltage boosting system of an HVDC flexible converter station according to the embodiment of the application;
Fig. 35 is a diagram of yet another low-voltage boosting system of an HVDC flexible converter station according to the embodiment of the application;
Fig. 36 is a diagram of still another low-voltage boosting system of an HVDC flexible converter station according to an embodiment of the application;
Fig. 37a is a diagram of a low-voltage power supply according to an embodiment of the application;
Fig. 37b is a diagram of another low-voltage power supply according to an embodiment of the application;
Fig. 37c a diagram of yet another low-voltage power supply according to an embodiment of the application;
Fig. 38 shows a flowchart of a charging control method for a first energy harvesting power supply according to an exemplary embodiment;
Fig. 39 is a flowchart of a bridge arm active voltage equalization control method according to an embodiment of the application;
Fig. 40 is a flowchart of a split-phase DC boosting control method according to an embodiment of the application; and
Fig. 41 is a flowchart of a low-voltage boosting control method for an HVDC flexible converter station according to an embodiment of the application.

### Detailed Description of Embodiments

Exemplary embodiments will be described more fully below with reference to the accompanying drawings. However, the exemplary embodiments can be implemented in various forms and should not be construed as limited to the embodiments set forth herein. These embodiments are provided to make this application more thorough and complete, and to fully convey the concept of the exemplary embodiments to those skilled in the art. In the drawings, the same reference numerals refer to the same or similar parts, so repeated descriptions will be omitted.

The flowchart shown in the drawings is only an exemplary illustration, and does not necessarily include all contents and operations/steps, nor does it have to be executed in the described order. For example, some operations/steps can be decomposed, while some operations/steps can be combined or partially combined, so the actual execution order may change according to the actual situation.

Terms such as "first" and "second" in the specification and claims and the drawings are used to distinguish different objects, but not to describe a specific order. Further, the terms "comprise" and "have" and any variations thereof are intended to cover non-exclusive inclusion. For example, a process, method, system, product or device comprising a series of steps or units is not limited to the steps or units, but optionally comprises steps or units not listed, or optionally comprises other steps or units inherent to the process, method, product or device.

Those skilled in the art can understand that the drawings are only diagrams of the exemplary embodiments. The modules or processes in the drawings are not necessarily a must for the implementation of this application, so they cannot be used to limit the scope of protection of this application.

A device embodiment of the application is described below, which can be used to execute the method embodiment of the application. For details not disclosed in the device embodiment of the application, please refer to the method embodiment of the application.

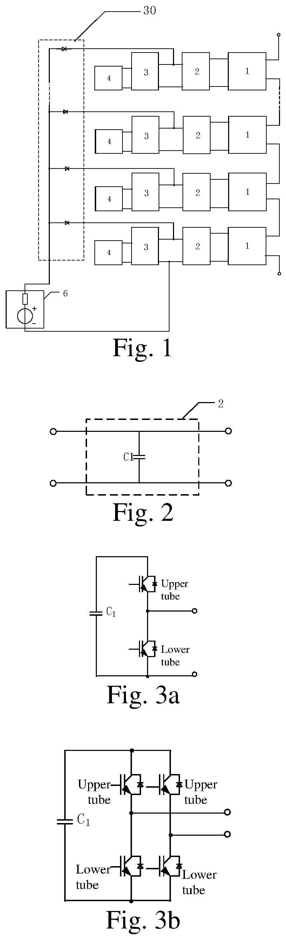

Fig. 1 is one of the composition diagrams of a modular converter circuit featuring batch energy harvesting according to an embodiment of the application.

A modular converter circuit featuring batch energy harvesting comprises N sub-modules, AC terminals of the N sub-modules are connected in series, unconnected AC terminals of a head-end sub-module and a tail-end sub-module are led out as AC terminals of the converter circuit, and N is an integer greater than or equal to 2.

The sub-module comprises a power unit 1, a capacitor unit 2, a transformer unit 3, a sub-module control unit 4, a batch energy harvesting unit and a bypass switch.

The power unit 1 comprises a power semiconductor device, and an AC terminal of the power unit 1 is led out as the AC terminal of the sub-module. The capacitor unit 2 is connected in parallel with the power unit 1, and comprises a first DC capacitor C1, as shown in Fig. 2. The transformer unit 3 is connected with the capacitor unit 2, and takes energy from the capacitor unit 2 to realize DC voltage conversion to supply power to the sub-module control unit 4. The sub-module control unit 4 is connected with the transformer unit 3 to control the power unit 1 to work. The batch energy harvesting unit comprises a first energy harvesting power supply 6 and a connection network 30. A negative electrode of the first energy harvesting power supply 6 is connected with a negative electrode of the capacitor unit of the head-end sub-module. An input terminal of the connection network 30 is directly connected with a positive electrode of the first energy harvesting power supply 6 or connected therewith through a current limiting unit, and the connection network 30 comprises N output terminals, which are respectively connected with positive electrodes of all the capacitor units directly or through current limiting units; and the current limiting unit comprises a resistor and/or an inductor. The bypass switch is connected to the AC terminal of the sub-module in parallel.

The power unit 1 comprises a half-bridge circuit or a full-bridge circuit, specifically, a two-level or three-level half-bridge circuit, or a two-level or three-level full-bridge circuit.

According to some embodiments, the half-bridge circuit comprises an upper tube and a lower tube, and the lower tube is connected in parallel with an AC output terminal of the sub-module, as shown in Fig. 3a.

According to some embodiments, the full-bridge circuit comprises two upper tubes and two lower tubes, the upper tubes and the lower tubes are connected in series to form a bridge arm, and the bridge arm is connected in parallel with the capacitor unit, and a midpoint of the bridge arm is led out as the AC output terminal of the sub-module, as shown in Fig. 3b.

According to some embodiments, the power units of the sub-modules in the converter circuit all have the same circuit, all of which are half-bridge circuits, or are all full-bridge circuits, or are a mixed configuration of full-bridge circuits and half-bridge circuits. Fig. 3c is a full-bridge sub-module circuit.

Optionally, the AC terminal of the sub-module is also connected in parallel with a bypass switch, which is electrically closed and maintained by mechanical force or magnetic force after being closed.

The zero-level state of the power unit is defined as follows: for a half-bridge circuit, a state that the lower tube is turned on is defined as the zero-level state; and for a full-bridge circuit, a state that the two upper tubes are turned on simultaneously or the two lower tubes are turned on simultaneously is defined as the zero-level state.

Optionally, the capacitor unit 2 further comprises a second DC capacitor C2 and an interface unit 5 connected between the first DC capacitor C1 and the second DC capacitor C2, and the second DC capacitor C2 is connected between the interface unit 5 and the transformer unit 3. The interface unit 5 is has a high impedance mode or a blocking mode.

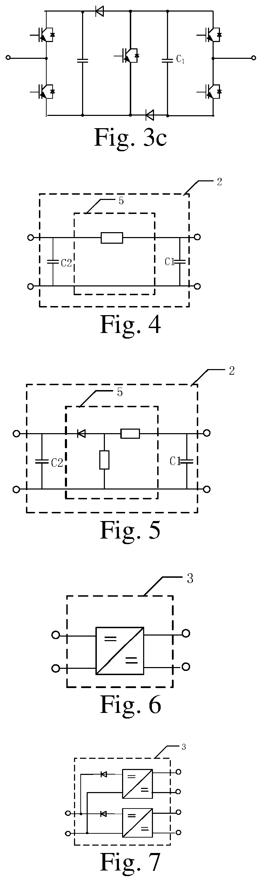

In the high impedance mode, the interface unit 5 comprises a resistor and/or a reactor, and the equivalent resistance of the interface unit 5 is greater than 10 kQ, as shown in Fig. 4.

In the blocking mode, the interface unit 5 comprises a blocking diode unit, a positive electrode of the blocking diode unit points to a positive electrode of the first DC capacitor C1, a negative electrode of the blocking diode unit points to a positive electrode of the second DC capacitor C2, and the blocking diode unit comprises a blocking diode, or a blocking diode and a voltage dividing resistor network, as shown in Fig. 5.

The transformer unit 3 comprises at least one DC converter, and an input terminal of the DC converter is connected with the capacitor unit 2, as shown in Fig. 6. When the number of DC converters is greater than 1, output terminals of the DC converters are directly connected in parallel or connected in parallel through series diodes, as shown in Fig. 7.

The connection network 30 comprises a parallel connection network or a series connection network.

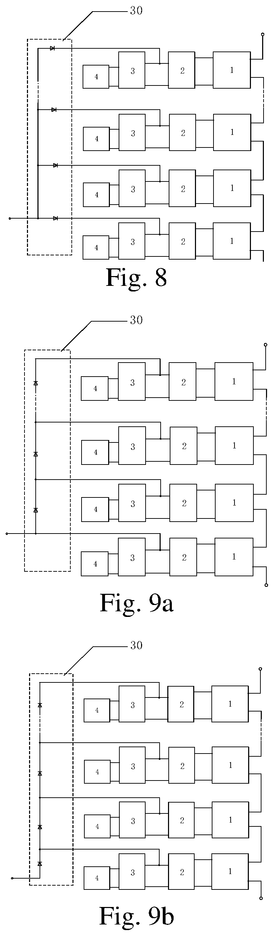

According to some embodiments, a parallel connection network comprises N diode units, positive electrodes of the N diode units are connected together as an input terminal of the connection network, and negative electrodes of the N diode units are sequentially led out as N output terminals of the connection network, as shown in Fig. 8. The diode unit comprises a diode, or a diode and a resistor and/or an inductor connected in series.

According to some embodiments, the series connection network comprises N-1 diode units, the N-1 diode units are connected in series in the same direction, a positive electrode of a first diode unit is used as an input terminal of the connection network, and positive electrodes of the N-1 diode units and a negative electrode of an (N-1)^{th} diode unit are sequentially led out as output terminals of the connection network, as shown in Fig. 9a.

According to some embodiments, the series connection network comprises N diode units, the N diode units are connected in series in the same direction, a positive electrode of a first diode unit is used as an input terminal of the connection network, and negative electrodes of N^{th} diode units are led out in turn as output terminals of the connection network, as shown in Fig. 9b. The diode unit comprises a diode, or a diode and a resistor and/or an inductor connected in series.

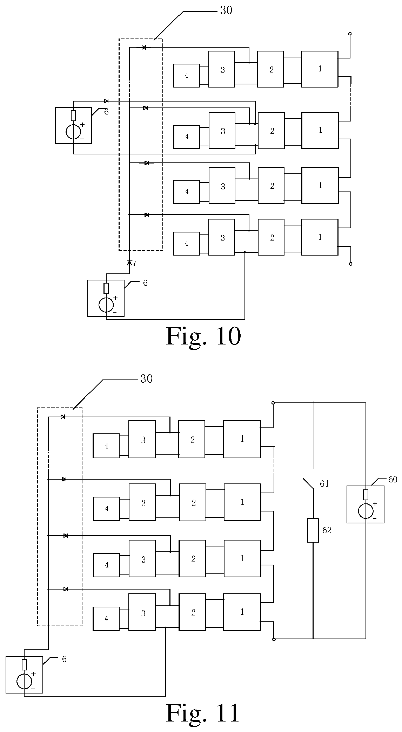

Optionally, when the connection network 30 is a series connection network, the converter circuit further comprises M first energy harvesting power supplies 6. The M first energy harvesting power supplies 6 are respectively connected in parallel with the capacitor units 2 of the sub-modules, where M is an integer, and 1≤M≤N-1. When M≥2, output terminals of the first energy harvesting power supplies 6 are connected in series with an anti-backflow diode, and a negative electrode of the anti-backflow diode points to positive electrodes of the capacitor units 2. In this embodiment, M=2, as shown in Fig. 10.

According to the modular converter circuit featuring batch energy harvesting provided by the technical scheme provided by this embodiment, a sub-module capacitor is divided into two capacitors, which realizes flexible adaptation according to different designs of internal power supply units; the capacitors can realize quick charging to supply power to the sub-module control unit, or a charging method equivalent to the real working condition can be adopted, but fewer external power supplies and lower voltage are used to ensure the safety of equipment and people; after the sub-module control unit is powered on, a communication point-to-point test can be carried out, and the step-by-step testing method can reduce test risks and improve test reliability; besides, an external secondary low-voltage power supply and a power supply from the sub-module capacitor constitute redundancy, which further ensures the controllable power supply of the sub-module.

Fig. 11 is a composition diagram of a synthetic loop system of a modular converter circuit featuring batch energy harvesting according to an embodiment of the application.

The synthetic loop system comprises a modular converter circuit featuring batch energy harvesting, a valve base control unit 50 and a second energy harvesting power supply 60. The valve base control unit 50 communicates with N sub-module control units 4. The second energy harvesting power supply 60 is connected with an AC terminal of the converter circuit.

Optionally, the synthetic loop system further comprises a discharge branch. The discharge branch is connected in parallel with the second energy harvesting power supply 60, and comprises a discharge switch 61 and a discharge resistor 62 connected in series, as shown in Fig. 11.

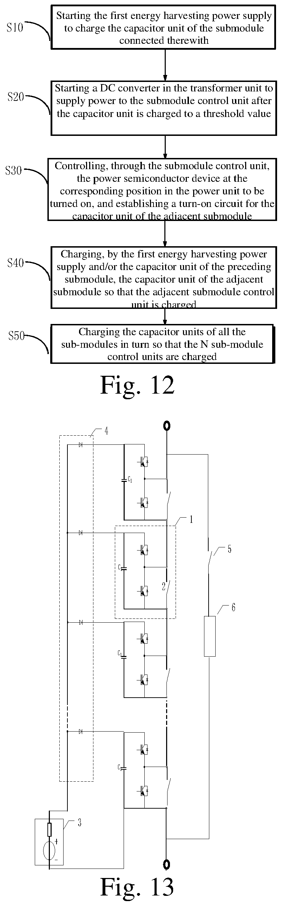

Fig. 12 is a flowchart of a charging control method of a modular converter circuit featuring batch energy harvesting according to an embodiment of the application, comprising the following steps:
S10, starting the first energy harvesting power supply 6 to charge the capacitor unit 2 of the sub-module connected therewith;
S20, starting a DC converter in the transformer unit 3 to supply power to the sub-module control unit 4 after the capacitor unit is charged to a threshold value;
S30, controlling, by the sub-module control unit 4, the power semiconductor device at the corresponding position in the power unit 1 to be turned on to realize a zero-level state of the power unit, so as to establish a turn-on loop for the capacitor unit of an adjacent sub-module;
S40, charging, by the first energy harvesting power supply 6 and/or the capacitor unit of a preceding sub-module, the capacitor unit of the adjacent sub-module so that the adjacent sub-module control unit is charged; and
S50, charging the capacitor units of all the sub-modules in turn so that the N sub-module control units 4 are charged.

When it is detected that a j^{th} sub-module fails or a (j+1)^{th} sub-module control unit cannot be normally charged, j is an integer, 1≤j≤N-1, and the following step is also conducted.

The bypass switch of the j^{th} sub-module is closed. If the (j+1)^{th} sub-module control unit still cannot be normally charged, charging is terminated and the j^{th} sub-module and/or the G+1)^{th} sub-module are overhauled. If the (j+1)^{th} sub-module control unit is normally charged, charging is continued, and the j^{th} sub-module is marked as faulty to be treated later.

Fig. 13 is another embodiment of a composition diagram of a modular converter circuit featuring batch energy harvesting according to the application.

As shown in Fig. 13, the modular converter circuit featuring batch energy harvesting comprises a converter valve, a low-voltage boosting unit and a load unit.

According to an exemplary embodiment, the converter valve comprises N sub-modules 1 with AC terminals being connected in series. N is an integer greater than or equal to 1.

According to an exemplary embodiment, in the sub-module 1, a half-bridge circuit or a full-bridge circuit is connected in parallel with a capacitor unit, and a power device is connected in parallel with a bypass switch 2.

According to some embodiments, the sub-module 1 further comprises a sub-module control unit.

According to some embodiments, the modular converter circuit featuring batch energy harvesting further comprises a valve control system, which communicates with the sub-module control unit.

According to an exemplary embodiment, the low-voltage boosting unit comprises a first energy harvesting power supply 3 and a connection network 4. The low-voltage boosting unit is connected with the capacitor unit of the sub-module.

According to an exemplary embodiment, the load unit comprises a discharge switch 5 and a discharge resistor 6, and the load unit is connected in parallel with the converter valve.

The first energy harvesting power supply is started, the discharge switch is closed, and the capacitor units of all the sub-modules are charged at the same time through the connection network and the discharge resistor.

According to some embodiments, a negative electrode of the first energy harvesting power supply is connected with a negative electrode of the capacitor unit of a head-end sub-module, an input terminal of the connection network is directly connected with a positive electrode of the first energy harvesting power supply, the connection network comprises N output terminals, and the N output terminals are respectively connected with positive electrodes of all the capacitor units.

According to some embodiments, the connection network has two connection modes: a parallel connection mode and a series connection mode.

According to an exemplary embodiment, Fig. 13 shows a parallel connection network, which comprises N diodes, positive electrodes of the N diode units are connected together as an input terminal of the connection network, and negative electrodes of the N diode units are sequentially led out as N output terminals of the connection network.

According to some embodiments, the modular converter circuit featuring batch energy harvesting can implement one or more of the following control methods:
1. batch trial pre-testing of sub-module functions: starting the first energy harvesting power supply, closing the discharge switch, and charging the capacitor unit of the sub-module through the connection network and the discharge resistor;
2. batch progressive boosting testing of sub-modules: starting the first energy harvesting power supply, controlling, by a sub-module control unit, the sub-module to output a zero-level state progressively, and charging the capacitor units of the sub-modules one by one, and performing sub-module function testing
3. batch rapid discharge testing of sub-modules: disconnecting the first energy harvesting power supply, closing the discharge switch, progressively turning on power semiconductor devices at corresponding positions in the power units through the sub-module control unit, and discharging the capacitor units of the sub-modules one by one; and
4. batch discharge bypass testing of sub-modules: discharging the capacitor unit of the sub-module to a constant value, and closing the bypass switch of the sub-module automatically.

According to some embodiments, the above control methods can be combined into one or more of the following:
1. batch trial pre-testing of sub-module functions and/or batch progressive boosting testing of sub-modules is performed first, and then the capacitor units of the sub-modules are naturally discharged;
2. batch trial pre-testing of sub-module functions and/or batch progressive boosting testing of sub-modules is performed first, then batch rapid discharge testing of sub-modules is performed, and then the capacitor units of the sub-modules are discharged quickly;
3. batch trial pre-testing of sub-module functions and/or batch progressive boosting testing of sub-modules is performed first, then batch rapid discharge testing of sub-modules and batch discharge bypass testing of sub-modules are performed, and then the capacitor units of the sub-modules are discharged quickly and the bypass switches are closed; and
4. batch trial pre-testing of sub-module functions and/or batch progressive boosting testing of sub-modules is performed first, then batch rapid discharge testing of sub-modules and batch discharge bypass testing of sub-modules are performed, then the capacitor units of the sub-modules are discharged quickly and the bypass switches are closed, then the bypass switches are manually separated, then batch trial pre-testing of sub-module functions and/or batch progressive boosting testing of sub-modules is performed again, after that, the capacitor units of the sub-modules are discharged naturally, or batch trial pre-testing of sub-module functions and/or batch progressive boosting testing of sub-modules is performed, then batch rapid discharge testing of sub-modules is performed, and after that, the capacitor units of the sub-modules are discharged quickly and whether the bypass switches are properly opened is checked.

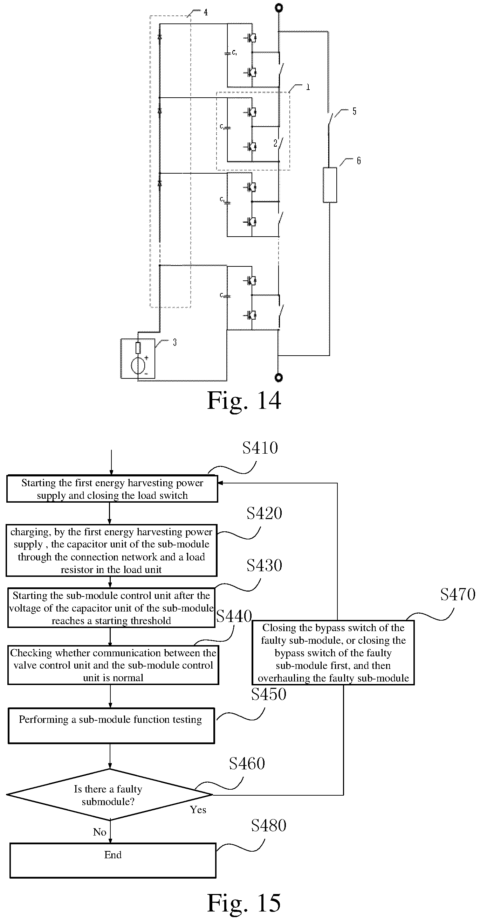

Fig. 14 shows a series connection network. The connection network comprises N-1 diode units, the N-1 diode units are connected in series in the same direction, a positive electrode of a first diode unit is used as an input terminal of the connection network, and positive electrodes of the N-1 diode units and a negative electrode of an (N-1)^{th} diode unit are sequentially led out as output terminals of the connection network, as shown in Fig. 14.

Fig. 15 shows a flowchart of a control method of batch trial pre-testing of sub-module functions according to an exemplary embodiment.

In S410, starting the first energy harvesting power supply and closing the load switch is closed.

According to an exemplary embodiment, the first energy harvesting power supply is started, and the load switch of the load unit is closed to form a closed loop.

In S420, charging, by the first energy harvesting power supply , the capacitor unit of the sub-module through the connection network and a load resistor in the load unit.

In S430, starting the sub-module control unit after the voltage of the capacitor unit of the sub-module reaches a starting threshold.

In S440, checking whether communication between the valve control unit and the sub-module control unit is normal.

According to an exemplary embodiment, whether communication between the valve control unit and the sub-module control unit is normal is checked, and if a communication failure occurs, a faulty sub-module is located.

In S450, performing a sub-module function testing.

In S460, determining whether there is a faulty sub-module.

According to an exemplary embodiment, if a faulty sub-module is detected, S470 is executed; and if there is no faulty sub-module, S480 is executed.

In S470, closing the bypass switch of the faulty sub-module, or closing the bypass switch of the faulty sub-module irst, and then overhauling the faulty sub-module.

According to an exemplary embodiment, if a sub-module fault is detected, the bypass switch of the faulty sub-module is closed, or the bypass switch of the faulty sub-module is closed first, then the faulty sub-module is overhauled, and then S410 is executed.

The flow ends at S480.

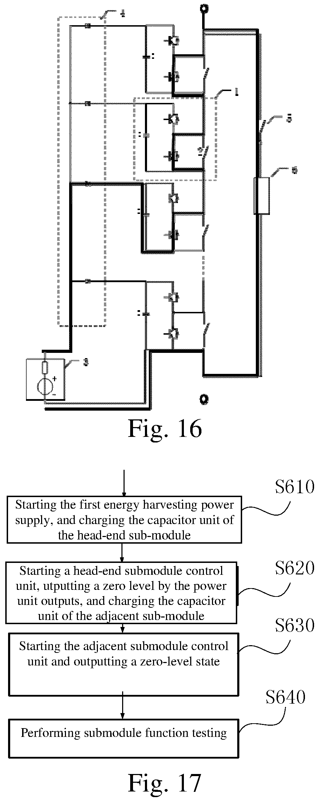

Fig. 16 shows a diagram of a sub-module charging circuit according to an exemplary embodiment.

As shown in Fig. 16, the first energy harvesting power supply charges the capacitor unit of the sub-module through the connection network and a load resistor in the load unit.

According to some embodiments, the capacitor units of the N sub-modules can be charged at the same time.

Fig. 17 shows a flowchart of a control method of batch progressive boosting testing of sub-modules according to an exemplary embodiment.

In S610, starting the first energy harvesting power supply, and charging the capacitor unit of the head-end sub-module.

According to an exemplary embodiment, the first energy harvesting power supply charges the capacitor unit of the sub-module directly connected to the negative electrode thereof.

In S620, starting a head-end sub-module control unit, outputting a zero level by the power unit outputs, and charging the capacitor unit of the adjacent sub-module.

According to some embodiments, for a half-bridge circuit, a state that the lower tube is turned on is defined as the zero-level state; and for a full-bridge circuit, a state that the two upper tubes are turned on simultaneously or the two lower tubes are turned on simultaneously is defined as the zero-level state.

According to an exemplary embodiment, after the charging of the capacitor unit of the head-end sub-module is completed, the head-end sub-module control unit is started, so that the power unit of the head-end sub-module is turned on, and the first energy harvesting power supply charges the capacitor unit of the adjacent sub-module.

In S630, starting the adjacent sub-module control unit and outputting a zero-level state by the adjacent sub-module control unit.

According to an exemplary embodiment, after charging the capacitor unit of the adjacent sub-module is completed, the power unit of the adjacent sub-module outputs zero level, and the capacitor unit of the next adjacent sub-module is charged. In this way, the capacitor units of all the sub-modules are charged progressively, and all the sub-module control units are started.

In S640, performing sub-module function testing.

According to some embodiments, the sub-module function testing comprises capacitor voltage sampling verification.

According to some embodiments, when a parallel connection network is adopted, the voltage sampling value of the capacitor unit of the i^{th} sub-module V_{SMi} =V_{S}-V_{D}-V_{G}^{∗}(i-1) or the sampling value V_{SMi}=V_{SM(i-1)}-V_{G};

According to some embodiments, when a series connection network is adopted, the voltage sampling value of the capacitor unit of the i^{th} sub-module V_{SMi} =Vs-V_{D}^{∗}(i-1)-V_{G}^{∗}(i-1) or V_{SMi}=V_{SM(i-1)}-V_{G}-V_{D};

where V_{Smi} is a voltage sampling value of the capacitor unit of the i^{th} sub-module, V_{SM(i-1)} isa voltage sampling value of the capacitor unit of the (i-1)^{th} sub-module, Vs is a voltage of the first energy harvesting power supply, V_{D} is a tube voltage drop of the diode, and V_{G} is a tube voltage drop of the power semiconductor device.

According to some embodiments, the sampling value calculated during capacitor voltage sampling verification according to the above theory is compared with the actual sampling value, and when the difference is higher than a threshold, it is determined that the test fails.

According to some embodiments, the sub-module function testing comprises cross communication verification, and cross communication has two types:
(1) the sub-module control unit communicates with the adjacent sub-module control unit in a crossing manner, and communicates with two different channels of the valve control unit at the same time; and
(2) a plurality of sub-module control units communicate in series, and the head and tail sub-module control units communicate with two different channels of the valve control unit.

Cross communication refers to reading the capacitor voltage sampling values of different sub-modules from the same channel of the valve control unit, and if the data conform to the corresponding relationship of capacitor voltage sampling verification, the verification is passed.

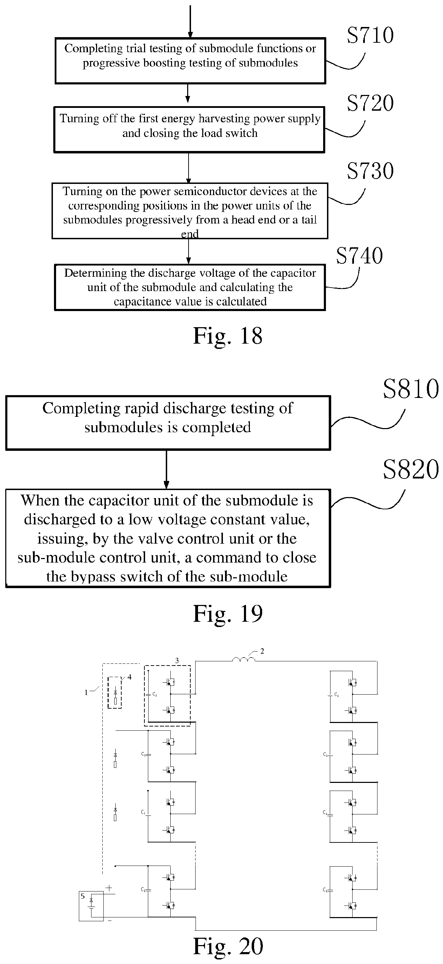

Fig. 18 shows a flowchart of a control method of batch rapid discharge testing of sub-modules according to an exemplary embodiment.

In S710, completing batch trial pre-testing of sub-module functions or batch progressive boosting testing of sub-modules.

In S720, turning off the first energy harvesting power supply is and closing the load switch.

In S730, turning on the power semiconductor devices at the corresponding positions in the power units of the sub-modules progressively from a head end or a tail end.

According to some embodiments, the power semiconductor device at the corresponding position refers to the upper tube of the half-bridge circuit or pair tubes of the full-bridge circuit.

According to an exemplary embodiment, the sub-module directly connected with the first energy harvesting power supply is the head-end sub-module, and the power semiconductor device at the corresponding position in the power unit of the head-end sub-module or the tail-end sub-module can be turned on.

In S740, calculating the theoretical voltage value according to the capacitance value of the capacitor unit of the sub-module, and determining the discharging voltage of the capacitor unit of the sub-module.

According to an exemplary embodiment, if the voltage deviation is higher than a threshold, the voltage deviation is recorded and an alarm is given.

Fig. 19 shows a flowchart of a control method of batch discharge bypass testing of sub-modules according to an exemplary embodiment.

In S810, completing batch rapid discharge testing of sub-modules.

In S820, when the capacitor unit of the sub-module is discharged to a low voltage constant value, issuing, by the valve control unit or the sub-module control unit, a command to close the bypass switch of the sub-module.

Fig. 20 is a diagram of a high voltage operation circuit of a converter valve provided by an embodiment of the application. The high voltage operation circuit of the converter valve comprises two converter circuits, a connection reactor 2, and one or two connection networks 1.

The two converter circuits comprise N sub-modules 3 and M sub-modules 3 respectively, where N and M are integers greater than or equal to 1. An AC terminal of the two converter circuits are connected via the connection reactor 2, and another AC terminal of the two converter circuits is short-circuited.

The sub-module 3 comprises a DC capacitor C1 and a power unit connected in parallel, and the power unit comprises a half-bridge circuit and/or a full-bridge circuit composed of power semiconductor devices. AC terminals of the sub-modules 3 are connected in series, and the AC terminals of a head-end sub-module and a tail-end sub-module are led out as the AC terminals of the converter circuits. An AC terminal of the two converter circuits are connected through the connection reactor 2, and another AC terminal thereof is short-circuited. The head-end sub-module is a sub-module connected with a positive electrode terminal of the connection network, and the tail-end sub-module is a sub-module connected with a negative electrode terminal of the connection network. The sub-module also comprises a sub-module control unit which controls the power unit to work.

The connection network 1 comprises at least N-1 or at least M-1 diode units 4.

The diode units 4 are connected in series in the same direction, the negative electrode terminal of the connection network 1 is connected with a positive electrode of the DC capacitor C1 of the tail-end sub-module, and positive electrode terminals of all the diode units 4 are in one-to-one correspondence with positive electrodes of the DC capacitors C1 of the sub-modules 3 of the corresponding converter circuit or connected therewith through a first current limiter. The diode unit comprises a diode, a positive electrode of the diode points to a positive electrode terminal of the diode unit, and a negative electrode points to a negative electrode terminal.

Optionally, the high voltage operation circuit of the converter valve further comprises at least one first energy harvesting power supply 5, and the first energy harvesting power supply 5 is connected in parallel with the DC capacitor of the head-end sub-module of the corresponding converter circuit. The first energy harvesting power supply 5 comprises a power supply unit, or a power supply unit and a diode connected in series, and the power supply unit comprises a DC power supply, or an AC power supply and a rectifier.

The output voltage of the first energy harvesting power supply 5 is fixed or adjustable. In this embodiment, the output voltage of the first energy harvesting power supply 5 is smaller than the voltage withstand value of the semiconductor device of the power unit of the sub-module. For example, if the voltage withstand value of the power semiconductor device is 3300 V, the output voltage of 1500V can be used for the first energy harvesting power supply 5.

When one converter circuit is configured with a connection network, there is one first energy harvesting power supply, which is connected in parallel with the DC capacitor of the head-end sub-module of the converter circuit configured with the connection network, as shown in Fig. 20.

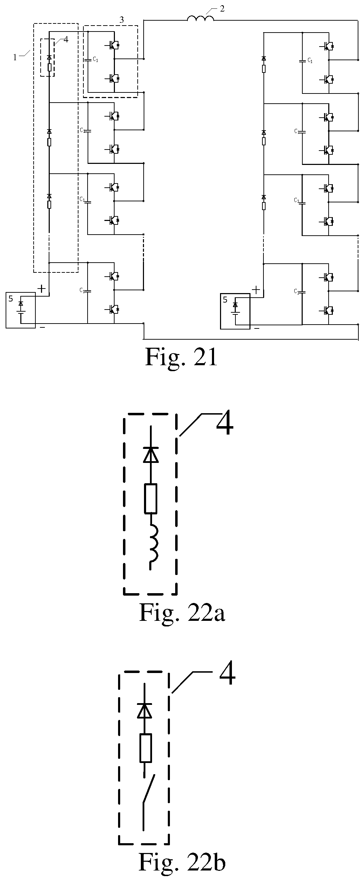

When both converter circuits are configured with connection networks, there are two first energy harvesting power supplies, which are respectively connected in parallel with the DC capacitors of the head-end sub-modules of the two converter circuits, as shown in Fig. 21.

According to the technical scheme provided by this embodiment, the power supply problem of many sub-modules can be solved through the first energy harvesting power supply with low voltage output, and the whole converter circuit can be charged through low voltage output, so that test conditions and test requirements are reduced, and this scheme is suitable for occasions where a high-voltage and high-power power supply is unavailable on site.

Optionally, the diode unit 4 further comprises a second current limiter, which is mainly used to limit current surges during charging. As shown in Fig. 22a, the second current limiter is connected in series with the diode, and the second current limiter comprises a resistor and/or an inductor.

Optionally, the diode unit further comprises an isolating switch, which is connected in series with the diode, and the opening and closing of the isolating switch are controlled by the sub-module control unit, as shown in Fig. 22b.

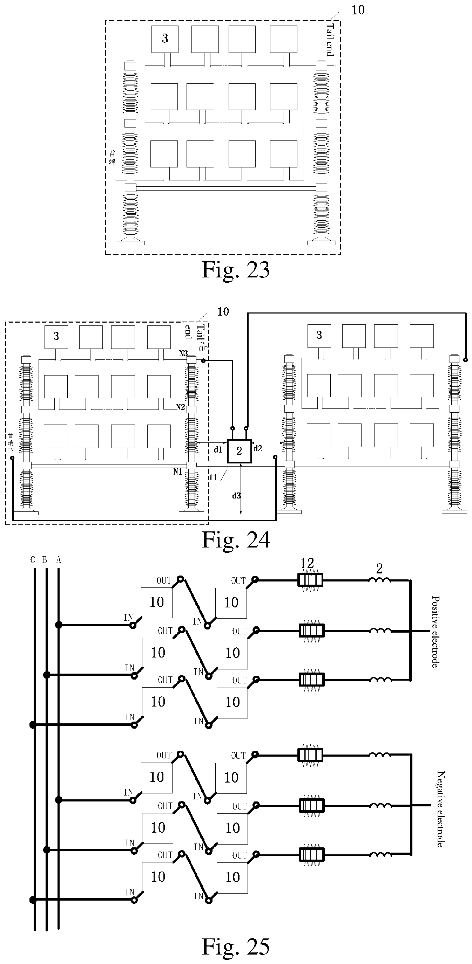

Fig. 23 is a diagram of a field test system for a high voltage operation circuit of a converter valve provided by an embodiment of the application, and the field test system of the high voltage operation circuit of the converter valve comprises at least one high voltage operation circuit of a converter valve.

Two converter circuits of the high voltage operation circuit of the converter valve are installed in the form of a valve tower, which is defined as an engineering valve tower 10.

As shown in Fig. 23, a cross beam is built between supporting insulators of the engineering valve tower, and the connection reactor 2 is installed on the cross beam 11. The cross beam can be built at N1, N2 and N3 insulation support positions, and the connection reactor 2 can also be placed on the ground separately.

An insulation distance d1 is maintained between the connection reactor 2 and a ground potential, and insulation distances d2 and d3 are maintained between the connection reactor 2 and the two engineering valve towers respectively, as shown in Fig. 24.

The connection reactor 2 comprises a bridge arm reactor or a combination of bridge arm reactors, and the connection reactor 2 is connected between the engineering valve towers 10.

In practical engineering application, the wiring mode is as shown in Fig. 25, involving six bridge arms in three phases. In this embodiment, each bridge arm comprises two engineering valve towers 10. Series connection ends of the two engineering valve towers are connected with AC, and another end is led out to be connected with the bridge arm reactor 2 through a through-wall bushing 12 and then connected with a positive electrode of the converter valve.

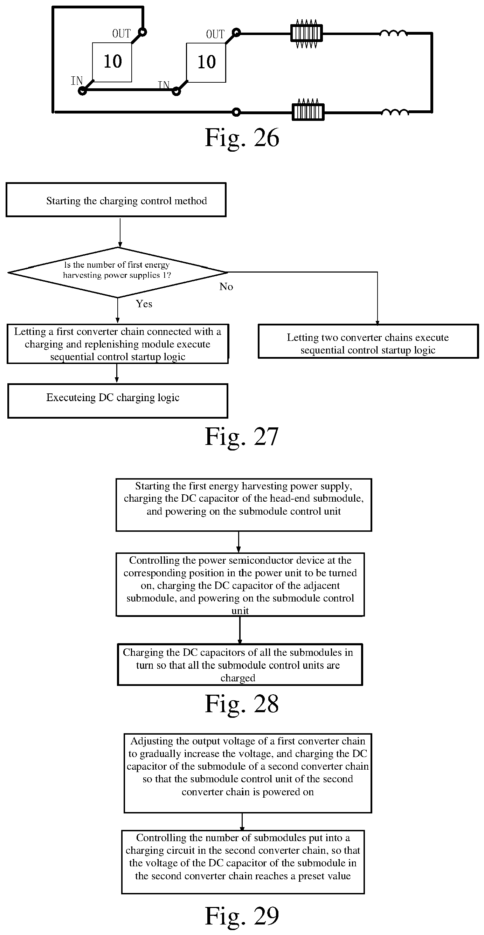

According to some embodiments, the existing wiring mode can also be modified, and the bridge arm reactor is used as the connection reactor 2. Taking a bridge arm as an example, the modified wiring mode is shown in Fig. 26. The modified operation circuit is the operation circuit shown in Fig. 20.

Fig. 27 is a flowchart of a control method for a high voltage operation circuit of a converter valve provided by an embodiment of the application, which comprises two control modes: cascade charging control and cascade operation control.

Cascade charging control uses the first energy harvesting power supply and a cascaded energy supply chain to charge the DC capacitors of all the sub-modules, and the sub-module control unit operates after taking power from the DC capacitor.

In cascade charging control, when there is one first energy harvesting power supply, the converter circuit connected with the first energy harvesting power supply is set as a first converter circuit, and the other converter circuit is a second converter circuit. The first converter circuit executes sequential control startup logic, and then executes DC charging logic to control output voltage and charge the sub-modules of the second converter circuit. When there are two first energy harvesting power supplies, the two converter circuits execute the sequential control startup logic separately.

According to some embodiments, the sequence control startup logic is shown in Fig. 28, which comprises: starting the first energy harvesting power supply to charge the DC capacitor of the head-end sub-module, so as to power on the head-end sub-module control unit; controlling, by the sub-module control unit, the power semiconductor device at the corresponding position in the power unit to be turned on to output a zero-level state, so as to establish a turn-one circuit for the DC capacitor of the adjacent sub-module, charge the DC capacitor of the adjacent sub-module to power on the sub-module control unit; and completing the charging of the DC capacitors of all the sub-modules in turn, so that all the sub-module control units are charged.

According to some embodiments, the DC charging logic is shown in Fig. 29, which comprises: adjusting the output voltage of the converter circuit connected with the first energy harvesting power supply to gradually increase the voltage from zero, so as to charge the DC capacitor of the sub-module of the second converter circuit until the sub-module control unit of the second converter circuit is powered on; and controlling the number of sub-modules put into a charging circuit in the second converter circuit, so that the voltage of the DC capacitor of the sub-module in the second converter circuit reaches a preset value.

For the cascade operation control, after the cascade charging control is completed, the two converter circuits control voltage and current to reproduce the voltage and current stress of the sub-module of the converter circuit, and the first energy harvesting power supply continuously supplements lost energy for the two converter circuits in this process.

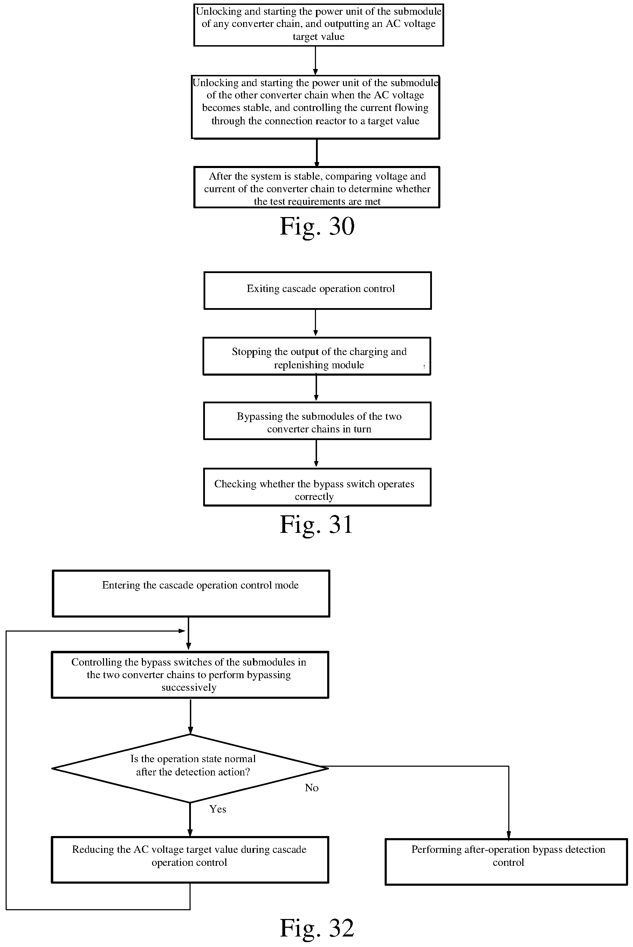

According to some embodiments, the cascade operation control is shown in Fig. 30, which comprises: unlocking and starting the power unit of the sub-module of any converter circuit, to output an AC voltage target value; unlocking and starting the power unit of the sub-module of another converter circuit when the AC voltage becomes stable, to control the current flowing through the connection reactor to a target value; and after the system is stable, detecting current and controlling the voltage and current of the converter circuit, and comparing the same with given values to determine whether the test requirements are met.

When the control method is applied to the field test system, the setting of the AC voltage target value is adjusted according to the insulation level of the connection reactor and d1, d2 and d3.

Optionally, the control method further comprises bypass switch detection control, namely, performing cascade operation control bypass detection and after-operation bypass detection to test whether the bypass switch can work normally.

According to some embodiments, the after-operation bypass detection is shown in Fig. 31, which comprises: exiting the cascade operation control; stopping the output of the first energy harvesting power supply; bypassing the sub-modules of the two converter circuits in turn; and checking whether the bypass switch operates correctly.

According to some embodiments, the cascade operation control bypass detection is shown in Fig. 32, which comprises: entering the cascade operation control; after stabilization, controlling the bypass switches of the sub-modules in the two converter circuits to conduct bypassing in turn; and if the operation state is normal after the detection operation, reducing the AC voltage target value during the cascade operation control; otherwise, performing the after-operation bypass detection.

The control method provided by this embodiment comprises start-up charging, cascade operation control and bypass detection. The control method covers the key items of converter valve testing. In the prior art, only the relevant tests of sub-modules can be completed in field testing of converter valves. The method proposed in this application realizes converter circuit testing and provides reliable guarantee for the engineering application of converter valves.

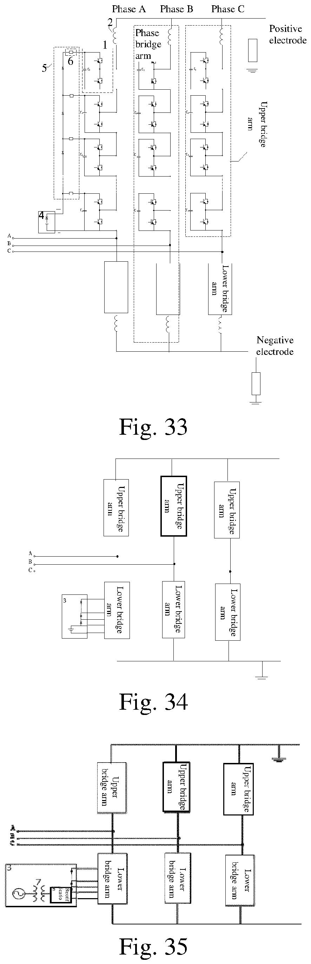

Fig. 33 is a diagram of a low-voltage boosting system of an HVDC flexible converter station according to an embodiment of the application.

This embodiment provides a low-voltage boosting system of an HVDC flexible converter station, and the HVDC flexible converter station comprises an HVDC flexible converter valve and a valve controller. As shown in Fig. 33, the HVDC flexible converter valve comprises three phase bridge arms connected in parallel: phase A, phase B and phase C. The phase bridge arms of phase A, phase B and phase C feature series connection of the upper bridge arm and the lower bridge arm, a positive terminal of the upper bridge arm is electrically connected with a DC positive electrode, a negative terminal of the upper bridge arm is electrically connected with a positive terminal of the lower bridge arm, and a negative terminal of the lower bridge arm is electrically connected with a DC negative electrode.

According to some embodiments, the low voltage of the low-voltage boosting system is 300-1500 V.

As shown in Fig. 33, taking phase A as an example, the upper bridge arm and the lower bridge arm are similar in structure, so the specific structure of the lower bridge arm is not drawn. The upper bridge arm comprises N sub-modules 1 and a bridge arm reactor 2, where N is an integer greater than or equal to 2. The sub-module 1 comprises two power semiconductor devices and one capacitor. A first power semiconductor device and a second power semiconductor device are connected in series in the same direction and then connected in parallel with the capacitor. The DC positive electrode is electrically connected with the bridge arm reactor 2, the other end of the bridge arm reactor 2 is electrically connected with a series midpoint of the two power semiconductor devices of the sub-module 1, and the other end of the second power semiconductor device is connected with a series midpoint of the two power semiconductor devices of the next sub-module; and the sub-modules are connected in series in turn, one end of the second power semiconductor device of the N^{th} sub-module is connected with a series midpoint of the two power semiconductor devices of the sub-module of the lower bridge arm, and one end of the second power semiconductor device of the N^{th} sub-module of the lower bridge arm is electrically connected with the bridge arm reactor and then electrically connected with the DC negative electrode.

According to an exemplary embodiment, the circuit structures of phase A, phase B and phase C are similar.

According to some embodiments, the sub-module 1 may be a half-bridge circuit, a full-bridge circuit, a three-level circuit or a combination thereof. The sub-module 1 also comprises a sub-module controller which can control the operation of the sub-module.

According to an exemplary embodiment, the valve controller communicates with the sub-module controller to control the operation of the low-voltage boosting system of the HVDC flexible converter station.

As shown in Fig. 33, the low-pressure boosting system 3 comprises a first energy harvesting power supply 4 and a connection network 5. The positive electrode of the first energy harvesting power supply 4 is electrically connected with the positive electrode of the connection network 5.

According to some embodiments, the connection network 5 comprises at least N-1 or 2N-1 diode units.

As shown in Fig. 33, in this embodiment, the connection network 5 is connected with phase A of the upper bridge arm and comprises N-1 diode units.

According to some embodiments, when the connection network 5 is connected with the phase bridge arm, the connection network contains 2N-1 diode units.

According to some embodiments, the diode unit comprises a diode, or a diode and a current limiting unit 6 connected in series.

As shown in Fig. 33, in this embodiment, the diode unit and the sub-module are connected through the current limiting unit.

According to an exemplary embodiment, the diode units are connected in series in the same direction, a positive electrode port of the diode is defined as a positive electrode terminal of the diode unit, and a negative electrode port of the diode is defined as a negative electrode terminal.

According to some embodiments, the positive electrode terminals of all the diode units and the negative electrode terminal of a tail-end diode unit form lead-out points the number of which is the same as that of the sub-modules, and are connected with the positive electrodes of the DC capacitors of the sub-modules in one-to-one correspondence or connected therewith in one-to-one correspondence through the current limiting unit 6.

As shown in Fig. 33, in this embodiment, the positive electrode terminals of all the diode units and the negative electrode terminal of a tail-end diode unit form lead-out points the number of which is the same as that of the sub-modules, and are connected with the positive electrodes of the DC capacitors of the sub-modules in one-to-one correspondence through the current limiting unit 6.

According to some embodiments, the current limiting unit 6 is composed of a resistor and/or an inductor.

According to an exemplary embodiment, when the absolute values of voltage to earth of DC positive and negative electrodes of the HVDC flexible converter valve are equal to or close to each other, the first energy harvesting power supply 4 is connected in parallel with the DC capacitor of the sub-module at the negative terminal of any upper bridge arm; and the connection network is sequentially connected with the positive electrodes of the DC capacitors of other sub-modules of the bridge arm.

When the DC negative electrode of the HVDC flexible converter valve is grounded, the first energy harvesting power supply 4 is connected in parallel with the DC capacitor of the sub-module at the negative terminal of any lower bridge arm or phase bridge arm; and the connection network is sequentially connected with the positive electrodes of the DC capacitors of other sub-modules of the bridge arm, as shown in Fig. 34.

When the DC positive electrode of the HVDC flexible converter valve is grounded, the first energy harvesting power supply 4 is connected in parallel with the DC capacitor of the sub-module at the negative terminal of any upper bridge arm, lower bridge arm or phase bridge arm through the isolation module 7, and the connection network is sequentially connected with the positive electrodes of the DC capacitors of other sub-modules of the bridge arm, as shown in Fig. 35. According to some embodiments, the isolation module 7 is an isolation transformer.

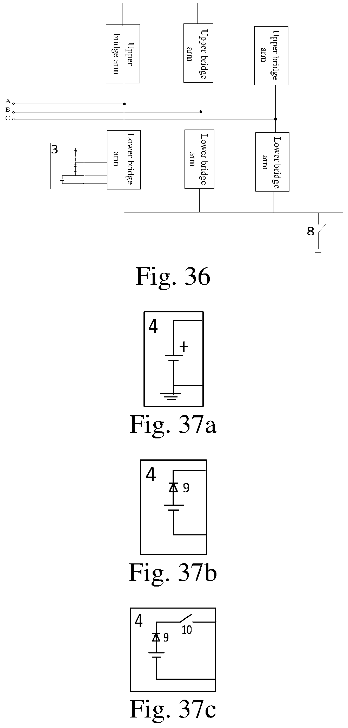

When the HVDC flexible converter valve is not grounded or grounded through a grounding switch and the grounding switch 8 is turned off, the first energy harvesting power supply 4 is connected in parallel with the DC capacitor of the sub-module at the negative terminal of any upper bridge arm, lower bridge arm or phase bridge arm, and the connection network is sequentially connected with the positive electrodes of the DC capacitors of other sub-modules of the bridge arm, as shown in Fig. 36.

The first energy harvesting power supply is a DC power supply, a negative electrode of which is grounded, as shown in Fig. 37a.

The first energy harvesting power supply comprises a diode 9 and a DC power supply, and a positive electrode of the diode 9 is connected with the positive electrode of the DC power supply, as shown in Fig. 37b.

The output of the first energy harvesting power supply is connected in series with a first high-voltage switch 10, and the isolation voltage level of the first high-voltage switch 10 is not lower than the AC side voltage of the flexible converter valve, as shown in Fig. 37c.

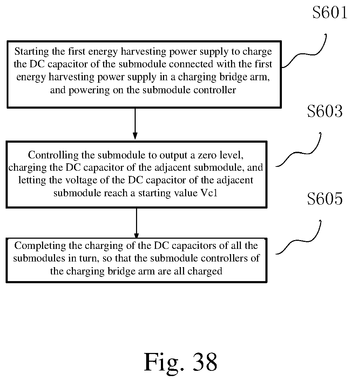

Fig. 38 shows a flowchart of a charging control method for a first energy harvesting power supply according to an exemplary embodiment.

In S601, starting the first energy harvesting power supply to charge the DC capacitor of the sub-module connected with the first energy harvesting power supply in a charging bridge arm, and powering on the sub-module controller.

According to an exemplary embodiment, assuming that the first energy harvesting power supply charges the upper bridge arm of phase A, the first energy harvesting power supply is started to charge the DC capacitor of the N^{th} sub-module of the upper bridge arm of phase A, and the N^{th} sub-module controller of the upper bridge arm of phase A is powered on to control the second power semiconductor of the N^{th} sub-module to be turned on.

In S603, controlling the sub-module to output a zero level, a charging circuit is established for the DC capacitor of the adjacent sub-module, and letting the voltage of the DC capacitor of the adjacent sub-module reach a starting value Vc1.

According to an exemplary embodiment, the sub-module controller of the upper bridge arm of phase A controls the sub-module to output a zero level, and establishes a charging circuit for the DC capacitor of the adjacent sub-module, that is, the second power semiconductor device of the N^{th} sub-module of the upper bridge arm of phase A is turned on, so that the voltage of the DC capacitor of the (N-1)^{th} sub-module of the upper bridge arm of phase A reaches the starting value Vc1, and the (N-1)^{th} sub-module controller is powered on to control the second power semiconductor device of the (N-1)^{th} sub-module to be turned on.

In S605, completing the charging of the DC capacitors of all the sub-modules in turn, so that the sub-module controllers of the charging bridge arm are all charged.

According to an exemplary embodiment, the upper bridge arm of phase A completes the charging of the DC capacitors of all the sub-modules in turn, the voltage of the DC capacitor of the sub-module of the upper bridge arm of phase A reaches the starting value Vc1, and the sub-module controllers of the charging bridge arm are all charged.

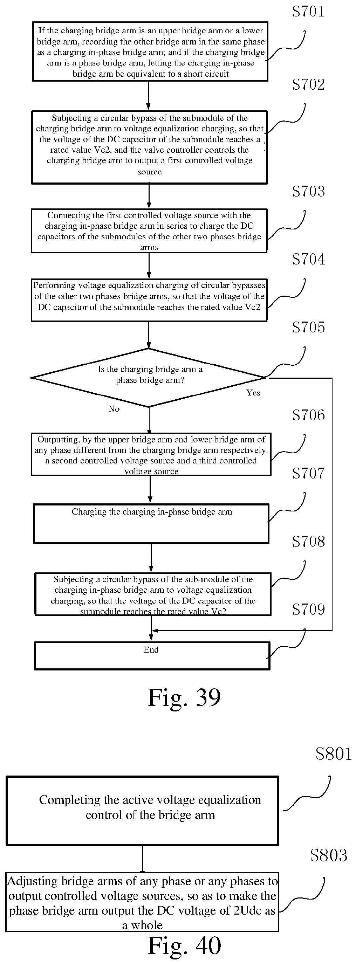

Fig. 39 is a flowchart of a bridge arm active voltage equalization control method according to an embodiment of the application.

In S701, if the charging bridge arm is an upper bridge arm or a lower bridge arm, recording the other bridge arm in the same phase as a charging in-phase bridge arm; and if the charging bridge arm is a phase bridge arm, letting the charging in-phase bridge arm be equivalent to a short circuit.

According to an exemplary embodiment, assuming that the first energy harvesting power supply charges the upper bridge arm of phase A, then the lower bridge arm of phase A is recorded as a charging in-phase bridge arm.

In S702, subjecting a circular bypass of the sub-module of the charging bridge arm to voltage equalization charging, so that the voltage of the DC capacitor of the sub-module reaches a rated value Vc2, and controlling, by the valve controller, the charging bridge arm to output a first controlled voltage source.

According to an exemplary embodiment, after the voltage of the DC capacitor of the upper bridge arm of phase A reaches Vc1, the second power semiconductor devices of the sub-modules of the upper bridge arm of phase A are controlled to be turned on in turn, so that the voltage of the DC capacitor of the sub-module reaches the rated value Vc2, and the voltage of the DC capacitor of the upper bridge arm of phase A is the output voltage of the first controlled voltage source.

In S703, connecting the first controlled voltage source with the charging in-phase bridge arm in series to charge the DC capacitors of the sub-modules of the other two phase bridge arms.

According to an exemplary embodiment, after the upper bridge arm of phase A is connected in series with the lower bridge arm, the DC capacitors of the sub-modules of the upper and lower bridge arms of phases B and C are charged, so that the voltage of the DC capacitors of the sub-modules of the upper and lower bridge arms of phases B and C reaches the starting value Vc1.

In S704, performing voltage equalization charging of circular bypasses of the sub-modules of the other two phase bridge arms separately or simultaneously, so that the voltage of the DC capacitor of the sub-module reaches the rated value Vc2.

According to an exemplary embodiment, after the voltage of the DC capacitors of the upper bridge arm and lower bridge arm of phases B and C reaches Vc1, the second power semiconductor devices of the sub-modules of the upper bridge arm and lower bridge arm of phases B and C are controlled to be turned on in turn, so that the voltage of the DC capacitor of the sub-module reaches the rated value Vc2.

In S705, determining whether the charging bridge arm is a phase bridge arm.

If the charging bridge arm is a phase bridge arm, the process ends; and if the charging bridge arm is not a phase bridge arm, the following steps are executed.

In S706, outputting, by the upper bridge arm and lower bridge arm of any phase different from the charging bridge arm respectively, a second controlled voltage source and a third controlled voltage source.

According to an exemplary embodiment, the valve controller controls the upper bridge arm and lower bridge arm of any phase different from the charging bridge arm to output the second controlled voltage source and the third controlled voltage source respectively. That is, the upper bridge arm and lower bridge arm of phase B and phase C respectively output the second controlled voltage source and the third controlled voltage source.

In S707, charging the charging in-phase bridge arm.

According to an exemplary embodiment, the first controlled voltage source, the second controlled voltage source and the third controlled voltage source form a circuit with the charging in-phase bridge arm to charge the charging in-phase bridge arm. That is, the upper bridge arm of phase A, and the upper bridge arm and lower bridge arm of phase B and phase C charge the lower bridge arm of phase A, so that the voltage of the DC capacitor of the sub-module of the lower bridge arm of phase A reaches Vc1.

In S708, subjecting a circular bypass of the sub-module of the charging in-phase bridge arm to voltage equalization charging, so that the voltage of the DC capacitor of the sub-module reaches the rated value Vc2.

According to an exemplary embodiment, after the voltage of the DC capacitor of the lower bridge arm of phase A reaches Vc1, the second power semiconductor devices of the sub-modules of the lower bridge arm of phase A are controlled to be turned on in turn, so that the voltage of the DC capacitor of the sub-module reaches the rated value Vc2.

The process ends at S709.

According to an exemplary embodiment, the active voltage equalization control of the bridge arm is completed, and the process ends.

Fig. 40 is a flowchart of a split-phase DC boosting control method according to an embodiment of the application.

In S801, completing the active voltage equalization control of the bridge arm.

The active voltage equalization control of the bridge arm is shown in Fig. 7.

In S803, adjusting bridge arms of any phase or any phases to output controlled voltage sources, so as to make the phase bridge arm output the DC voltage of 2Udc as a whole.

According to an exemplary embodiment, the first controlled voltage source, the second controlled voltage source and the third controlled voltage source can all output DC voltage, so that the phase bridge arm can output the DC voltage of 2Udc as a whole.

According to an exemplary embodiment, the magnitude of the DC voltage Udc can be adjusted using the following two methods: adjusting the number of sub-modules outputting voltage Vc2 in the upper and/or lower bridge arm; or adjusting the rated voltage value Vc2 of the DC capacitor of each sub-module in the upper and/or lower bridge arm.

Here, Udc=Vc2*P, P is the number of sub-modules outputting voltage Vc2 in the upper or lower bridge arm, and P is finally stabilized at N/2.

According to an exemplary embodiment, the rising rate of the DC voltage output by the controlled voltage source can be adjusted, and discharge current is controlled to be less than a preset value. In this state, the controlled voltage source charges other bridge arms on a DC bus, while a DC power supply in its own sub-module is in a discharging state. Therefore, if the adjustment rate of the output DC voltage is too fast, the discharge current will be too large, so it is necessary to reasonably select the rising rate and control the discharge current to be less than the preset value.

According to an exemplary embodiment, to simulate actual working conditions, the second controlled voltage source and the third controlled voltage source are synthesized voltage Uac1 and Uac2 respectively, and the synthesized voltage is obtained by superimposing of AC voltage Uac and DC voltage Udc, where Uac1=Udc+Uac, Uac2=Udc-Uac, Uac1+Uac2=2Udc.

According to an exemplary embodiment, the split-phase DC boosting control method determines whether the sub-module works normally by putting in different phases or switching different sub-modules and observing output voltage and waveforms.

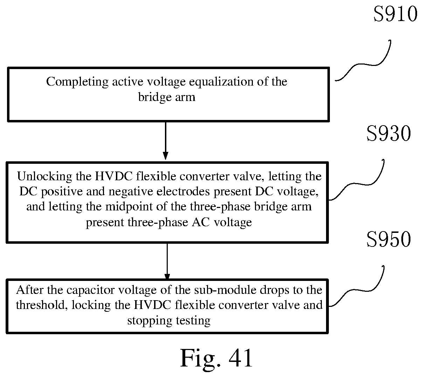

Fig. 41 is a flowchart of a low-voltage boosting control method for an HVDC flexible converter station according to an embodiment of the application.

In S910, completing active voltage equalization of the bridge arm.

According to an exemplary embodiment, active voltage equalization of the bridge arm is completed, as shown in Fig. 7; and if there is a first high-voltage switch 10 in the first energy harvesting power supply, the first high-voltage switch 10 is turned off.

In S930, unlocking the HVDC flexible converter valve, letting the DC positive and negative electrodes present DC voltage, and letting the midpoint of the three-phase bridge arm present three-phase AC voltage.

In S950, after the capacitor voltage of the sub-module drops to the threshold, locking the HVDC flexible converter valve and stopping testing.

According to an exemplary embodiment, the sub-module consumes electric energy during operation, making the capacitor voltage of the sub-module drop to a certain threshold, and then the HVDC flexible converter valve is locked and testing is stopped.

According to exemplary embodiments, the application also has one or more of the following auxiliary benefits:
1. voltage withstand testing and sampling calibration are performed on DC and AC accessory equipment during boosting; and
2. when insulation breakdown occurs during boosting, the safety of equipment is ensured by means of rapid overcurrent protection of the bridge arm and/or short-circuit protection of the power semiconductor device; rapid overcurrent protection of the bridge arm is to detect the current of the bridge arm through the valve controller, and lock the HVDC flexible converter valve and stop testing when the current exceeds an action threshold; and short-circuit protection of the power semiconductor device is to lock and bypass the sub-module immediately after the sub-module controller detects a short-circuit fault of the power device, report the fault to the valve controller, and lock the HVDC flexible converter valve and stop testing when more than a certain number of sub-modules fail at the same time.

It should be clearly understood that this application describes how to form and use specific examples, but this application is not limited to any details of these examples. On the contrary, based on the teachings of the disclosure, these principles can be applied to many other embodiments.

In addition, it should be noted that the above drawings are only illustrations of the processes included in the method according to the exemplary embodiments of the application, and are not for limiting purposes. It is easy to understand that the processes shown in the above figures do not indicate or limit the time sequence of these processes. In addition, it is also easy to understand that these processes can be performed synchronously or asynchronously in multiple modules, for example.

Exemplary embodiments of the application have been particularly shown and described above. It should be understood that this application is not limited to the detailed structure, arrangement or implementation described here; on the contrary, this application is intended to cover various modifications and equivalent arrangements included within the spirit and scope of the appended claims.

## Claims

1. A modular converter circuit featuring batch energy harvesting, comprising a batch energy harvesting unit and N sub-modules, AC terminals of the N sub-modules being connected in series, and N being an integer greater than or equal to 2, wherein
the sub-module comprises:
a power unit comprising a power semiconductor device, an AC terminal of the power unit being led out as the AC terminal of the sub-module; and
a capacitor unit connected in parallel with the power unit, and
the batch energy harvesting unit comprises:
a first energy harvesting power supply, a negative electrode of the first energy harvesting power supply being connected with a negative electrode of the capacitor unit of a head-end sub-module among the N sub-modules or connected therewith through a current limiting unit; and
a connection network, an input terminal of the connection network being directly connected with a positive electrode of the first energy harvesting power supply or connected therewith through a current limiting unit, and N output terminals of the connection network being respectively connected with positive electrodes of the capacitor units or connected therewith through current limiting units.

2. The converter circuit according to claim 1, wherein
the power units of the sub-modules in the converter circuit are all half-bridge circuits, all full-bridge circuits, or a mixed configuration of full-bridge circuits and half-bridge circuits;
the half-bridge circuit comprises an upper tube and a lower tube, the upper tube and the lower tube are connected in series and then connected in parallel with the capacitor unit, and a collector and an emitter of the upper tube or the lower tube are led out as the AC terminal of the sub-module;
the full-bridge circuit comprises two upper tubes and two low tubes, the two upper tubes and the two lower tubes are connected in series to form a bridge arm and the bridge arm is connected in parallel with the capacitor unit, and a midpoint of the bridge arm is led out as the AC output terminal of the sub-module; and
the upper tubes and the lower tubes are fully controlled power semiconductor devices or formed by parallel connection of the devices.

3. The converter circuit according to claim 1, wherein the connection network comprises:
a parallel connection network comprising N diode units, positive electrodes of the N diode units being connected together as the input terminal of the connection network, and negative electrodes of the N diode units being sequentially led out as N output terminals of the connection network; or
a series connection network comprising any of the following two Types:
Type 1 comprising N diode units connected in series in a same direction, a positive electrode of a first diode unit being used as the input terminal of the connection network, and negative electrodes of N^{th} diode units being led out in turn as the output terminals of the connection network; and
Type 2 comprising N-1 diode units connected in series in a same direction, a positive electrode of a first diode unit being used as the input terminal of the connection network, and a positive electrode of the first diode and a negative electrode of an (N-1)^{th} diode unit being sequentially led out as the output terminals of the connection network;
wherein the diode unit comprises a diode, or a diode and a resistor and/or an inductor connected in series.

4. The converter circuit according to claim 1, further comprising:
bypass switches connected in parallel with the AC terminals of the sub-modules; and
a discharge branch being connected in parallel with the converter circuit, and comprising a discharge switch and a discharge resistor connected in series and/or a resonant circuit formed by an inductor and/or an inductor capacitor.

5. The converter circuit according to claim 1, wherein the head-end sub-module is a sub-module with a lowest potential in the converter circuit.

6. A method for controlling the converter circuit according to any one of claims 1-5, comprising one or a combination of the following steps:
batch trial pre-testing of sub-module functions: starting the first energy harvesting power supply, closing the discharge switch, and charging the capacitor unit of the sub-module through the connection network and the discharge resistor;
batch progressive boosting testing of sub-modules: starting the first energy harvesting power supply, controlling, by a sub-module control unit, the sub-modules to output a zero-level state progressively, and charging the capacitor units of the sub-modules one by one, and performing sub-module function testing;
batch rapid discharge testing of sub-modules: after the batch trial pre-testing of sub-module functions or the batch progressive boosting testing of sub-modules is completed, disconnecting the first energy harvesting power supply, closing the discharge switch, progressively turning on power semiconductor devices at corresponding positions in the power units through the sub-module control unit, and discharging the capacitor units of the sub-modules one by one; and
batch discharge bypass testing of sub-modules: after the batch rapid discharge testing of sub-modules is completed, discharging the capacitor unit of the sub-module to a constant value, and closing the bypass switch of the sub-module automatically.

7. The control method according to claim 6, wherein the batch progressive boosting testing of sub-modules comprises:
starting the first energy harvesting power supply to charge the capacitor unit of the sub-module connected therewith;
supplying power to the sub-module control unit after the capacitor unit is charged to a threshold value;
controlling, by the sub-module control unit, the power semiconductor device at the corresponding position in the power unit to be turned on to realize a zero-level state of the power unit, so as to establish a turn-on loop for the capacitor unit of an adjacent sub-module;
charging, by the first energy harvesting power supply or the capacitor unit of a preceding sub-module, the capacitor unit of the adjacent sub-module so that the sub-module control unit of the adjacent sub-module is charged; and
charging the capacitor units of all the sub-modules in turn so that the N sub-module control units are charged.

8. The control method according to claim 6, wherein
for a half-bridge circuit, a state that the low tube of the power semiconductor device is turned on is defined as the zero-level state; and
for a full-bridge circuit, a state that the two upper tubes of the power semiconductor device are turned on simultaneously or the two lower tubes of the power semiconductor device are turned on simultaneously is defined as the zero-level state.

9. A high voltage operation circuit, comprising:
the modular converter circuit featuring batch energy harvesting according to any one of claims 1-3 and a second converter circuit, wherein
the second converter circuit comprises M sub-modules, AC terminals of the M sub-modules are connected in series, and M is an integer greater than or equal to 2; or the second converter circuit comprises the converter circuit featuring batch energy harvesting according to any one of claims 1-3;
AC terminals of a head-end sub-module and a tail-end sub-module of the second converter circuit are led out as AC terminals of the second converter circuit; and
the converter circuit featuring batch energy harvesting is connected with an AC terminal of the second converter circuit through a connection reactor, and another AC terminal thereof is short-circuited.

10. A method for controlling the high voltage operation circuit according to claim 9, comprising:
cascade charging control: using the first energy harvesting power supply and the connection network to charge the capacitor units of all the sub-modules, and after the sub-module control unit takes power from the capacitor units, enabling the sub-module control unit to operate; and
cascade operation control: after the cascade charging control is completed, controlling voltage and current by the converter circuit featuring batch energy harvesting and the second converter circuit, and supplementing lost energy for the converter circuit featuring batch energy harvesting and the second converter circuit by the first energy harvesting power supply.

11. A low-voltage boosting system of an HVDC flexible converter station, wherein the HVDC flexible converter station comprises an HVDC flexible converter valve and a valve controller;
the HVDC flexible converter valve comprises three phase bridge arms connected in parallel, the phase bridge arm is formed by series connection of an upper bridge arm and a lower bridge arm, a positive terminal of the upper bridge arm is connected with a DC positive electrode, a negative terminal of the upper bridge arm is connected with a positive terminal of the lower bridge arm, and a negative terminal of the lower bridge arm is connected with a DC negative electrode;
the corresponding upper bridge arm or lower bridge arm or phase bridge arm is configured as the converter circuit featuring batch energy harvesting according to any one of claims 1-5 according to a grounding mode of the HVDC flexible converter valve, and other bridge arms are configured as converter circuits where sub-modules are connected in series; and
the valve controller communicates with a sub-module control unit controlling operation of the sub-modules.

12. The low-voltage boosting system of the HVDC flexible converter station according to claim 11, wherein a configuration mode has one of the following corresponding relationships with the grounding mode:
the DC negative electrode of the HVDC flexible converter valve is grounded, and at least one lower bridge arm or phase bridge arm is configured as the converter circuit featuring batch energy harvesting;
the DC positive electrode of the HVDC flexible converter valve is grounded, the first energy harvesting power supply is isolated from the capacitor unit by an isolation module, and the upper bridge arm, the lower bridge arm or the phase bridge arm is configured as the converter circuit featuring batch energy harvesting;
when absolute values of the voltage to ground of the DC positive electrode and the DC negative electrode of the HVDC flexible converter valve are equal to or close to each other, the upper bridge arm or the phase bridge arm is configured as the converter circuit featuring batch energy harvesting; and
the HVDC flexible converter valve is not grounded or grounded through a grounding switch turned off, and the upper bridge arm, the lower bridge arm or the phase bridge arm is configured as the converter circuit featuring batch energy harvesting.

13. A method for controlling the low-voltage boosting system of the HVDC flexible converter station according to any one of claims 11-12, comprising:
charging, by the first energy harvesting power supply, the DC capacitor of the sub-module configured as the converter circuit featuring batch energy harvesting, the converter circuit featuring batch energy harvesting being defined as a charging bridge arm;
starting the charging bridge arm after charging of the charging bridge arm is completed, to output controllable voltage to charge other bridge arms of the HVDC flexible converter valve; and
controlling the upper bridge arm and the lower bridge arm of any phase to be voltage sources after charging of the other bridge arms is completed, and equivalently applying DC voltage to the DC positive electrode and the DC negative electrode, which is defined as a boosting process.

14. The method according to claim 13, further comprising: turning off a first high-voltage switch connected in series with the first energy harvesting power supply after charging of the three-phase bridge arm is completed, and unlocking the three-phase bridge arm, such that the DC positive electrode and the DC negative electrode feature a DC voltage, and a midpoint of the three-phase bridge arm features a three-phase AC voltage.

15. The method according to claim 13, further comprising:
performing voltage withstand testing and/or sampling calibration on DC, AC equipment or AC/DC lines during boosting; and
ensuring safety of equipment by means of rapid overcurrent protection of the bridge arm and/or short-circuit protection of the power semiconductor device when insulation breakdown occurs in the process of boosting.

16. A field test method for a converter valve, wherein the converter valve comprises six bridge arms and a valve control unit, the bridge arm comprises the converter circuit according to any one of claims 1-5, the converter circuit comprises N sub-modules, and the sub-modules are connected with a valve control unit by optical fibers; and the field test method comprises:
connecting N output terminals of the connection network to positive electrodes of the capacitor units of the N sub-modules;
starting the first energy harvesting power supply;
identifying, by the valve control unit, whether the sub-module established by communication is consistent with a physical position; and
performing batch energy harvesting, and performing function testing on the sub-modules or updating a program of the valve control unit.
